(19) Europäisches Patentamt
European Patent Office
Office européen des brevets

(11) **EP 3 644 065 A1**

(12) **EUROPEAN PATENT APPLICATION**
published in accordance with Art. 153(4) EPC

(43) Date of publication:
**29.04.2020 Bulletin 2020/18**

(51) Int Cl.:
***G01N 35/08*** (2006.01)   ***B81B 1/00*** (2006.01)
***G01N 37/00*** (2006.01)

(21) Application number: **18821343.3**

(22) Date of filing: **25.05.2018**

(86) International application number:
**PCT/JP2018/020171**

(87) International publication number:
**WO 2018/235524 (27.12.2018 Gazette 2018/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.06.2017 JP 2017119345**

(71) Applicant: **Sekisui Chemical Co., Ltd.
Osaka-shi, Osaka 530-8565 (JP)**

(72) Inventors:
• **IMAMURA, Kazuhiko
  Mishima-gun
  Osaka 618-0021 (JP)**

• **INUI, Nobuhiko
  Mishima-gun
  Osaka 618-0021 (JP)**
• **KOBARU, Shotaro
  Mishima-gun
  Osaka 618-0021 (JP)**
• **KOUNO, Takamasa
  Mishima-gun
  Osaka 618-0021 (JP)**
• **TAKAMATSU, Tatsunori
  Mishima-gun
  Osaka 618-0021 (JP)**
• **ISHII, Ryoma
  Mishima-gun
  Osaka 618-0021 (JP)**

(74) Representative: **Ter Meer Steinmeister & Partner
Patentanwälte mbB
Nymphenburger Straße 4
80335 München (DE)**

(54) **MICRO FLUID DEVICE**

(57)    Provided is a micro fluid device capable of reliably performing measurement of a fluid into a branched flow path and dispensing of a predetermined amount of a fluid into a plurality of the branched flow paths. A micro fluid device is provided in which a micro flow path 11 has a main flow path 12 and branched flow paths 15 to 17, the main flow path 12 has a first expanded flow path portion 12d, the branched flow paths 15 to 17 have second expanded flow path portions 15c to 17c, and a difference (TB-TE) between a TB value as a T value in the branched flow path and a TE value as a T value in the main flow path is 5 or more, with respect to a T value represented by the following formula (1):

$$T = \{1/(x^2 \cdot R)\} \cdot (\theta/90) \ldots \text{Formula (1)}$$

where x is a flow path width at a starting point of the first, second expanded flow path portion; R is a radius of curvature of curved surface portion in the first, second expanded flow path portion; and $\theta$ indicates a central angle of a circular arc with a radius of curvature R having the starting point of the first, second expanded flow path portion and an end point of the expanded flow path portion as end portions.

EP 3 644 065 A1

[FIG. 2.]

**Description**

**TECHNICAL FIELD**

The present invention relates to a micro fluid device having an injection molding made of synthetic resin.

**BACKGROUND ART**

Various micro fluid devices have been proposed for biochemical analysis and the like. In order to send a fluid and stop the fluid at a predetermined portion, it is necessary for a micro flow path to have portions each having different liquid sending resistance. Patent Document 1 below discloses a structure in which an expanded flow path portion is provided which rapidly expands a flow path cross section of a micro flow path. It is supposed that a fluid can be stopped by increase in liquid sending resistance in the expanded flow path portion.

**Related Art Document**

**Patent Document**

JP 2002-527250 T

**SUMMARY OF THE INVENTION**

**PROBLEMS TO BE SOLVED BY THE INVENTION**

In the above-mentioned micro fluid device, an injection molding made of synthetic resin is widely used to achieve miniaturization and cost reduction. In order to manufacture such an injection molding made of synthetic resin, an inner surface of the flow path needs to be curved at an inflection point at which the flow path of the expanded flow path portion changes rapidly. Otherwise, it would be difficult to remove the injection molding from a mold.
However, when the inner surface of the flow path has a curved surface in the vicinity of the inflection point, a radius of curvature of a curved surface portion causes a difference in flowability of a fluid. Therefore, for example, when a main flow path is provided with the expanded flow path portion and a branched flow path is provided with the expanded flow path portion, the fluid may not be reliably measured and apportioned into the branched flow path side in some cases. That is, there is a possibility that the fluid may flow out to the downstream side from the branched flow path as a measurement portion.
Even when a fluid is dispensed into a plurality of branched flow paths, there is a possibility that the fluid cannot be reliably dispensed into each branched flow path.
An object of the present invention is to provide a micro fluid device capable of reliably performing measurement of a fluid into a branched flow path and dispensing of a fluid into a plurality of branched flow paths.

**MEANS FOR SOLVING THE PROBLEMS**

A micro fluid device according to the present invention includes an injection molding made of a synthetic resin and a micro flow path. In this micro fluid device, the micro flow path includes a main flow path having a branched portion, and a first expanded flow path portion that is provided at a downstream side of the branched portion and that increases flow path resistance; and a branched flow path being connected to the branched portion of the main flow path and having a second expanded flow path portion that is provided at the downstream side of the branched portion and in which flow path resistance is increased. A flow path inner surface in the first, second expanded flow path portion has a curved shape, and when a flow path width at a starting point of the first, second expanded flow path portion is x, a radius of curvature in a case where the flow path inner surface with a curved shape is viewed in plan is R, and a central angle of a circular arc with a radius R having the starting point of the first, second expanded flow path portion and an end point of the first, second expanded flow path portion as end portions is θ, a difference between a TB value as a T value in the branched flow path and a TE value as a T value in the main flow path satisfies TB-TE ≥ 5, with respect to a T value represented by formula (1) below:

$$T = \{1/(x^2 \cdot R)\} \cdot (\theta/90) \quad (1)\ldots\text{Formula (1)}.$$

In a certain specific aspect of the micro fluid device according to the present invention, the micro fluid device includes a plurality of the branched portions, a plurality of branched flow paths are connected one by one to the plurality of the branched portions, and TB-TE ≥ 19 is satisfied with respect to each of the branched flow paths. In this case, a fluid can be reliably dispensed into the plurality of branched flow paths.

In another specific aspect of the micro fluid device according to the present invention, the micro fluid device further includes a connection flow path connecting the second expanded flow path portions of the plurality of branched flow paths.

In still another specific aspect of the micro fluid device according to the present invention, the micro fluid device further includes a waste liquid portion connected to the first expanded flow path portion.

In yet another specific aspect of the micro fluid device according to the present invention, the branched flow path is further provided with a narrowed portion that is connected to an upstream side of the second expanded flow path portion and whose flow path is narrower than the second expanded flow path portion and a remaining portion of the branched flow path.

In still another specific aspect of the micro fluid device according to the present invention, the micro fluid device further includes a liquid sending means on an upstream side of the main flow path.

## EFFECT OF THE INVENTION

The micro fluid device according to the present invention having an injection molding can reliably measure a predetermined amount of a fluid in the branched flow path, and can reliably dispense a predetermined amount of a fluid in the plurality of the branched flow paths.

## BRIEF DESCRIPTION OF DRAWINGS

[Fig. 1] Fig. 1 is a perspective view showing an appearance of a micro fluid device according to one embodiment of the present invention.
[Fig. 2] Fig. 2 is a schematic plan view for describing a micro flow path of the micro fluid device according to one embodiment of the present invention.
[Fig. 3] Fig. 3 is a schematic plan view for describing a flow path width x, a radius of curvature R, and an angle θ.
[Fig. 4] Fig. 4 is a schematic cross-sectional view showing a direction in which a flow path cross section is expanded.
[Fig. 5] Fig. 5 is a schematic plan view for describing a curved surface portion in an expanded flow path portion when the angle θ is 120°.
[Fig. 6] Fig. 6 is a schematic plan view for describing the curved surface portion in the expanded flow path portion when the angle θ is 60°.

## MODE(S) FOR CARRYING OUT THE INVENTION

The present invention will be clarified with reference to the drawings through illustration of specific preferred embodiments of the present invention.

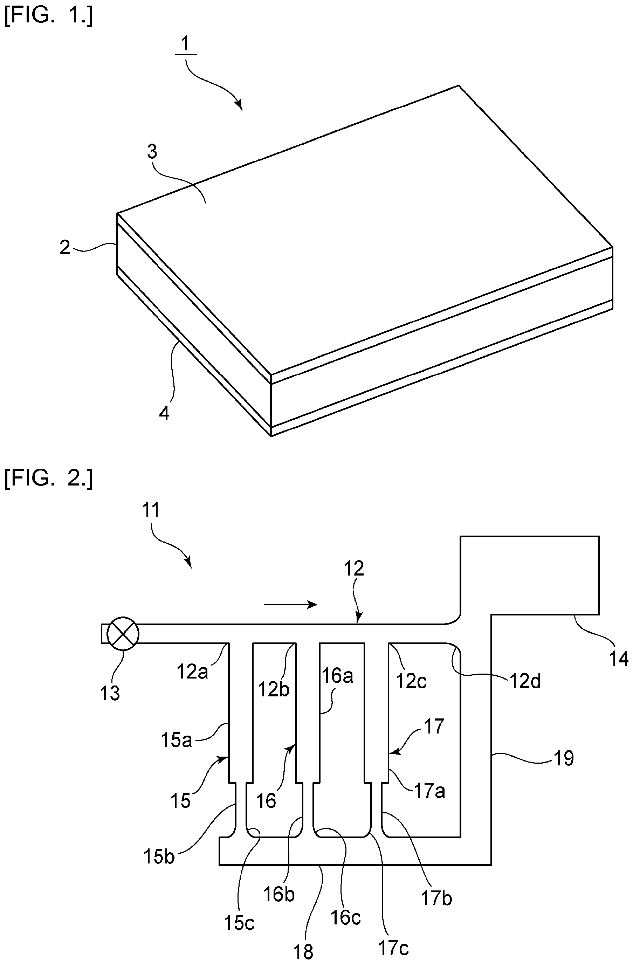

Fig. 1 is a perspective view showing an appearance of a micro fluid device according to one embodiment of the present invention. A micro fluid device 1 has a substrate 2 including an injection molding made of synthetic resin. A cover sheet 3 is stacked on the substrate 2, and a base sheet 4 is stacked on a lower surface of the substrate 2. The cover sheet 3 and the base sheet 4 include an elastomer or an inorganic synthetic resin. A micro flow path is provided in the substrate 2.

The micro flow path refers to such a minute flow path that causes a micro effect when a liquid (micro liquid) is conveyed.

In such a micro flow path, the liquid is strongly affected by surface tension and behaves differently from a liquid flowing in a normal large-sized flow path.

The cross-sectional shape and size of the micro flow path are not particularly limited as long as the micro flow path causes the above-mentioned micro effect. For example, in the case of using a pump or gravity when a fluid flows in the micro flow path, from the viewpoint of reducing flow path resistance, the dimension of the smaller side is preferably 20 μm or more, more preferably 50 μm or more, and still more preferably 100 μm or more when the cross-sectional shape of the micro flow path is generally rectangular (including a square). From the viewpoint of miniaturization of the micro fluid device, the dimension of the smaller side is preferably 5 mm or less, more preferably 1 mm or less, and still more preferably 500 μm or less. When the cross-sectional shape of the micro flow path is generally circular, the diameter (short diameter in the case of an ellipse) is preferably 20 μm or more, more preferably 50 μm or more, and still more

preferably 100 $\mu$m or more. From the viewpoint of miniaturization of the micro fluid device, the diameter (short diameter in the case of an ellipse) is preferably 5 mm or less, more preferably 1 mm or less, and still more preferably 500 $\mu$m or less.

On the other hand, for example, in the case of effectively using a capillary phenomenon when a fluid flows in the micro flow path, the dimension of the smaller side is preferably 5 $\mu$m or more, more preferably 10 $\mu$m or more, still more preferably 20 $\mu$m or more, preferably 200 $\mu$m or less, and more preferably 100 $\mu$m or less when the cross-sectional shape of the micro flow path is generally rectangular (including a square).

As shown in Fig. 2, a micro flow path 11 has a main flow path 12. A micropump 13 as a liquid sending means is provided on an upstream side of the main flow path 12.

The main flow path 12 is provided with a plurality of branched portions 12a to 12c. In addition, a first expanded flow path portion 12d is provided on a downstream side of the portion where the branched portions 12a to 12c are provided. The first expanded flow path portion 12d is a portion where a flow path cross section of the main flow path 12 is rapidly expanded. The first expanded flow path portion 12d determines the liquid sending resistance of the fluid conveyed through the main flow path 12.

A waste liquid portion 14 is connected to the first expanded flow path portion 12d.

Branched flow paths 15 to 17 are connected to the branched portions 12a to 12c, respectively. The branched flow paths 15 to 17 have branched flow path body portions 15a to 17a connected to the branched portions 12a to 12c. Post-branching flow path narrowed portions 15b to 17b are connected to downstream ends of the branched flow path body portions 15a to 17a. Second expanded flow path portions 15c to 17c are connected to downstream ends of the post-branching flow path narrowed portions 15b to 17b. Downstream ends of the second expanded flow path portions 15c, 16c, and 17c are connected to a connection flow path 18. A bypass flow path 19 is provided so as to connect the first expanded flow path portion 12d and the connection flow path 18.

The sizes of the flow path cross sections of the post-branching flow path narrowed portions 15b 16b, and 17b are smaller than those of the flow path cross sections of the second expanded flow path portions 15c, 16c, and 17c and the branched flow path body portions 15a, 16a, and 17a as the remaining portions of the branched flow paths 15, 16, and 17. The second expanded flow path portions 15c, 16c, and 17c are portions where the flow path cross sections are rapidly expanded, thereby giving fluid resistance to the fluid in the branched flow paths 15, 16 and 17.

The feature of the present embodiment is that TB-TE is set to 5 or more, and more preferably 19 or more, with respect to a T value represented by the following formula (1). The TB value is a T value in the second expanded flow path portions 15c, 16c, and 17c of the branched flow paths 15, 16, and 17, and the TE value is a T value in the first expanded flow path portion 12d of the main flow path 12.

$$T = \{1/(x^2 \cdot R)\} \cdot (\theta/90) \quad (1) \ldots \text{Formula (1)}$$

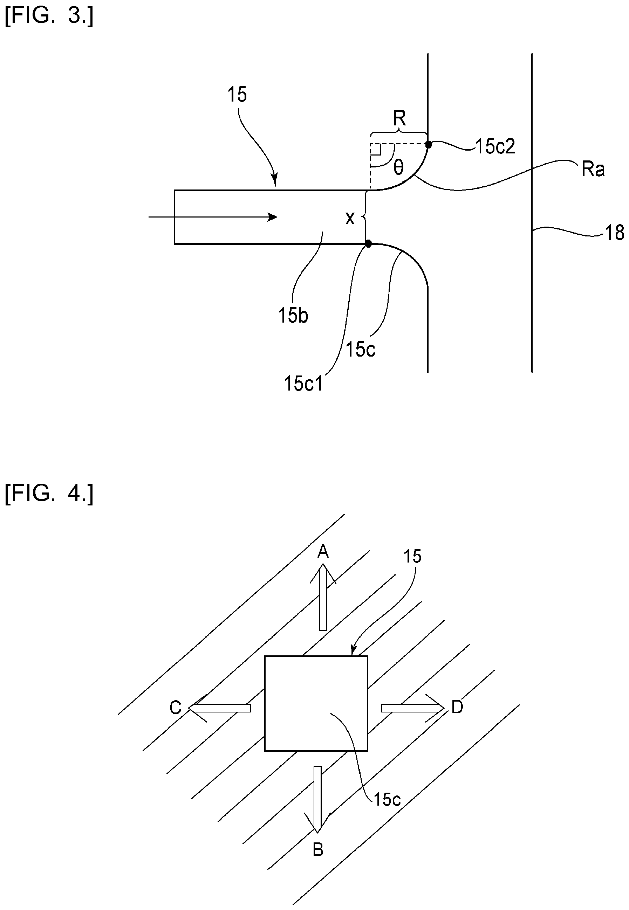

The T value will be described with reference to Fig. 3. Fig. 3 is a schematic expanded plan view of a portion where the post-branching flow path narrowed portion 15b of the branched flow path 15 and the second expanded flow path portion 15c are connected as one representative example. Here, a flow path width x in the formula (1) refers to a flow path width (unit: $\mu$m) at a starting point 15c1 of the second expanded flow path portion 15c.

The flow path cross section in the second expanded flow path portion 15c gradually increases. Here, since the substrate 2 including the injection molding is used, it is necessary that an inner wall of the flow path is in a curved shape as in the second expanded flow path portion 15c, in order to perform injection molding. In the second expanded flow path portion 15c, when the curved surface portion is viewed in plan, the radius of curvature is R (unit: $\mu$m). $\theta$(°) is the central angle of a circular arc Ra with the radius R having the starting point 15c1 and an end point 15c2 of the second expanded flow path portion 15c as end portions. Thus, in Fig. 3, $\theta$ is 90°.

In the expanded flow path portion, although the flow path cross section in the second expanded flow path portion 15c gradually increases in plan view, the flow path cross section changes to gradually increase in the vertical direction as shown by arrows A and B in Fig. 4 and in the horizontal direction as shown by arrows C and D.

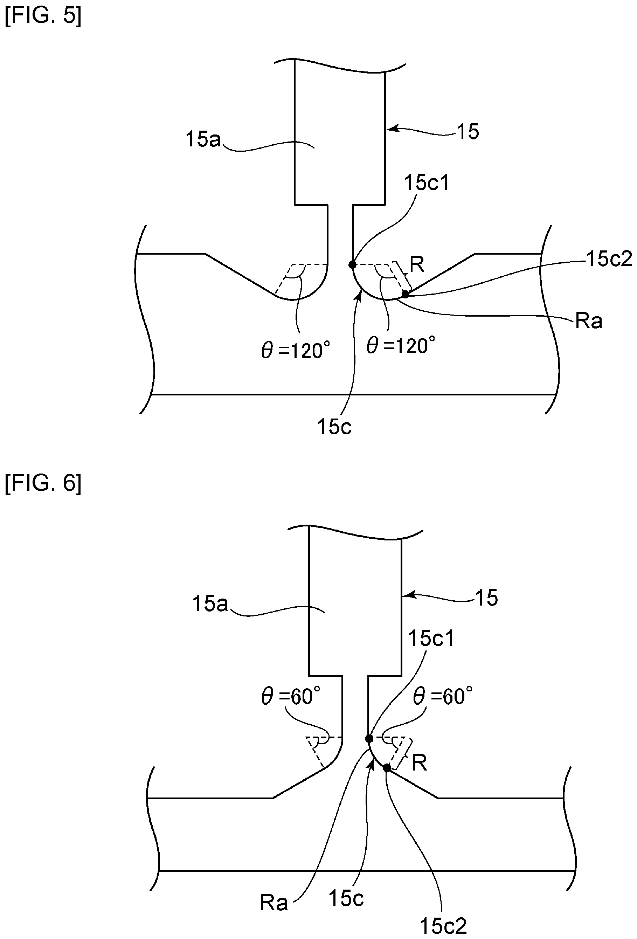

In Fig. 3, the angle $\theta$ = 90°. Figs. 5 and 6 are schematic plan views each showing a curved surface portion of the second expanded flow path portion 15c when $\theta$ is 120° or 60°. As shown in Fig. 5, the circular arc Ra with the radius R has the starting point 15c1 and the end point 15c2 as end portions. In Fig. 5, the central angle $\theta$ of the circular arc Ra is 120°. In Fig. 6, the central angle $\theta$ of the circular arc Ra is 60°.

In the micro fluid device 1, the TB-TE described above is set to 5 or more and more preferably 19 or more in the micro flow path 11, so that a predetermined amount of a fluid is measured in the branched flow paths 15, 16, and 17, or a predetermined amount of a fluid can be reliably dispensed into the branched flow paths 15, 16, and 17. This will be described with reference to the following experimental examples.

(Experimental Examples 1 to 16)

The micro fluid device 1 was prepared in which the cover sheet 3 and the base sheet 4 were stacked on the substrate 2 which is an injection molding made of a cycloolefin polymer. In the micro fluid device 1, the micro flow path 11 having the two branched flow paths 15 and 16 was provided with various dimensions. Table 1 shows design parameters of the expanded flow path portions used as the first, second expanded flow path portion 12d, 15c, or 16c. T1 to T36 in Table 1 indicate the numbers of the expanded flow path portions.

As Experimental Examples 1 to 16, the second expanded flow path portion and the first expanded flow path portion were made to have dimensions indicated by T numbers, and each of the micro fluid devices 1 was manufactured, as shown in Table 2 below. Table 2 shows the TB values and the TE values together.

[Table 1]

| T number | x ($\mu$m) | R ($\mu$m) | $\theta$ (°) | T |
|---|---|---|---|---|
| T1 | 1 | 0.2 | 60 | 3.333333333 |
| T2 | 1 | 0.2 | 90 | 5 |
| T3 | 1 | 0.2 | 120 | 6.666666667 |
| T4 | 1 | 0.4 | 60 | 1.666666667 |
| T5 | 1 | 0.4 | 90 | 2.5 |
| T6 | 1 | 0.4 | 120 | 3.333333333 |
| T7 | 1 | 0.6 | 60 | 1.111111111 |
| T8 | 1 | 0.6 | 90 | 1.666666667 |
| T9 | 1 | 0.6 | 120 | 2.222222222 |
| T10 | 0.7 | 0.2 | 60 | 6.802721088 |
| T11 | 0.7 | 0.2 | 90 | 10.20408163 |
| T12 | 0.7 | 0.2 | 120 | 13.60544218 |
| T13 | 0.7 | 0.4 | 60 | 3.401360544 |
| T14 | 0.7 | 0.4 | 90 | 5.102040816 |
| T15 | 0.7 | 0.4 | 120 | 6.802721088 |
| T16 | 0.7 | 0.6 | 60 | 2.267573696 |
| T17 | 0.7 | 0.6 | 90 | 3.401360544 |
| T18 | 0.7 | 0.6 | 120 | 4.535147392 |
| T19 | 0.5 | 0.2 | 60 | 13.33333333 |
| T20 | 0.5 | 0.2 | 90 | 20 |
| T21 | 0.5 | 0.2 | 120 | 26.66666667 |
| T22 | 0.5 | 0.4 | 60 | 6.666666667 |
| T23 | 0.5 | 0.4 | 90 | 10 |
| T24 | 0.5 | 0.4 | 120 | 13.33333333 |
| T25 | 0.5 | 0.6 | 60 | 4.444444444 |
| T26 | 0.5 | 0.6 | 90 | 6.666666667 |
| T27 | 0.5 | 0.6 | 120 | 8.888888889 |
| T28 | 0.2 | 0.2 | 60 | 83.33333333 |
| T29 | 0.2 | 0.2 | 90 | 125 |
| T30 | 0.2 | 0.2 | 120 | 166.6666667 |

(continued)

| T number | x (μm) | R (μm) | θ (°) | T |
|----------|--------|--------|-------|-----------|
| T31 | 0.2 | 0.4 | 60 | 41.66666667 |
| T32 | 0.2 | 0.4 | 90 | 62.5 |
| T33 | 0.2 | 0.4 | 120 | 83.33333333 |
| T34 | 0.2 | 0.6 | 60 | 27.77777778 |
| T35 | 0.2 | 0.6 | 90 | 41.66666667 |
| T36 | 0.2 | 0.6 | 120 | 55.55555556 |

[Table 2]

| Experimental Example | Second expanded flow path portion | | First expanded flow path portion | | TB-TE |
|----------------------|-----------|------|-----------|------|-------|
| | T number | TB | T number | TE | |
| 1 | T29 | 125 | T11 | 10.2 | 114.8 |
| 2 | T29 | 125 | T20 | 20 | 105 |
| 3 | T32 | 62.5 | T11 | 10.2 | 52.3 |
| 4 | T34 | 27.8 | T21 | 26.7 | 1.1 |
| 5 | T32 | 62.5 | T21 | 26.7 | 35.8 |
| 6 | T36 | 55.6 | T21 | 26.7 | 28.9 |
| 7 | T31 | 41.7 | T25 | 4.44 | 37.26 |
| 8 | T20 | 20 | T11 | 10.2 | 9.8 |
| 9 | T20 | 20 | T12 | 13.6 | 6.4 |
| 10 | T23 | 10 | T14 | 5.1 | 4.9 |
| 11 | T23 | 10 | T2 | 5 | 5 |
| 12 | T12 | 13.6 | T1 | 3.33 | 10.27 |
| 13 | T11 | 10.2 | T2 | 5 | 5.2 |
| 14 | T2 | 5 | T6 | 3.33 | 1.67 |
| 15 | T2 | 5 | T5 | 2.5 | 2.5 |
| 16 | T21 | 26.7 | T15 | 6.8 | 19.9 |

As shown in Table 2, for example in Experimental Example 1, the TB value of the branched flow path is 125 since the expanded flow path portion with T29 is provided. On the other hand, in Experimental Example 1, the TE value is 10.2 since the expanded flow path portion with T11 is provided. Therefore, the TB-TE is 114.8.

As described above, the micro fluid devices 1 of Experimental Examples 1 to 16 different in TB-TE were manufactured.

An aqueous solution having a contact angle of 90° was sent into the micro fluid device 1 using the micropump 13. When a predetermined amount of the fluid could be dispensed into the two branched flow paths 15 and 16, the result during the dispensing was judged as good (o) in Table 3 below. When a predetermined amount of the fluid could not be reliably dispensed into the plurality of branched flow paths 15 and 16, it was judged as poor (×).

[Table 3]

| Experimental Example | | 1 | 2 | 3 | 4 | 5 | 6 | 7 | 8 | 9 | 10 | 11 | 12 | 13 | 14 | 15 | 16 |
|---|---|---|---|---|---|---|---|---|---|---|---|---|---|---|---|---|---|
| Dispensing | Two branched flow paths | ○ | ○ | ○ | × | ○ | ○ | ○ | × | × | × | × | × | × | × | × | ○ |
| TB-TE | | 115 | 105 | 52.3 | 1.1 | 35.8 | 28.9 | 37.3 | 9.8 | 6.4 | 4.9 | 5 | 10.3 | 5.2 | 1.67 | 2.5 | 19.9 |

As apparent from Table 3, it can be seen that when the TB-TE is 19 or more, the fluid can be reliably dispensed into the branched flow paths 15 and 16.

(Experimental examples 17 to 32)

Next, a micro fluid device having one branched flow path described above was manufactured in the same manner as described above. That is, the micro fluid device 1 was manufactured in the same manner as in the above-mentioned Experimental Examples 1 to 16 except that only the single branched flow path 15 was connected to a main flow path and the branched flow path 16 was not provided. The TB values of the branched flow paths were the same as those in Experimental Examples 1 to 16, and the micro fluid devices 1 of Experimental Examples 17 to 32 were manufactured. Then, in the same manner as in Experimental Examples 1 to 16, an aqueous solution having a contact angle of 90° was sent, and it was confirmed whether or not a 5 μL amount of the fluid was reliably measured in the single branched flow path. When the measurement was reliably performed, it was judged as good (o) in Table 4 below, and when the measurement was not reliably performed, it was judged as poor (×).

[Table 4]

| Experimental Example | Single branched flow path | 17 | 18 | 19 | 20 | 21 | 22 | 23 | 24 | 25 | 26 | 27 | 28 | 29 | 30 | 31 | 32 |
|---|---|---|---|---|---|---|---|---|---|---|---|---|---|---|---|---|---|
| Measurement | | ○ | ○ | ○ | × | ○ | ○ | ○ | ○ | ○ | ○ | ○ | ○ | ○ | × | × | ○ |
| TB-TE | | 115 | 105 | 52.3 | 1.1 | 35.8 | 28.9 | 37.3 | 9.8 | 6.4 | 4.9 | 5 | 10.3 | 5.2 | 1.67 | 2.5 | 19.9 |

As apparent from Table 4, it can be seen that when the TB-TE is 5 or more, a predetermined amount of the fluid can be reliably measured in a single branched flow path.

Although the fluid that can be used is not particularly limited, if a fluid having a contact angle in the range of 70° to 130° is used, it is confirmed that the fluid can be reliably measured or dispensed in accordance with the present invention as in the above-mentioned Experimental Examples 1 to 32.

**EXPLANATION OF SYMBOLS**

| 1: | Micro fluid device |
| 2: | Substrate |
| 3: | Cover sheet |
| 4: | Base sheet |
| 11: | Micro flow path |
| 12: | Main flow path |
| 12a to 12c: | Branched portion |
| 12d: | First expanded flow path portion |
| 13: | Micropump |
| 14: | Waste liquid portion |
| 15 to 17: | Branched flow path |
| 15a to 17a: | Branched flow path body portion |
| 15b to 17b: | Post-branching flow path narrowed portion |
| 15c to 17c: | Second expanded flow path portion |
| 15c1: | Starting point |
| 15c2: | End point |
| 18: | Connection flow path |
| 19: | Bypass flow path |

**Claims**

1. A micro fluid device comprising:

an injection molding made of a synthetic resin; and
a micro flow path,
the micro flow path comprising:

a main flow path having a branched portion, and a first expanded flow path portion that is provided at a downstream side of the branched portion and that increases flow path resistance; and
a branched flow path being connected to the branched portion of the main flow path and having a second expanded flow path portion that is provided at the downstream side of the branched portion and in which flow path resistance is increased,

a flow path inner surface in the first, second expanded flow path portion having a curved shape, and
when a flow path width at a starting point of the first, second expanded flow path portion is x, a radius of curvature in a case where the flow path inner surface with a curved shape is viewed in plan is R, and a central angle of a circular arc with a radius of curvature R having the starting point of the first, second expanded flow path portion and an end point of the first, second expanded flow path portion as end portions is θ, a difference between a TB value as a T value in the branched flow path and a TE value as a T value in the main flow path satisfying TB-TE ≥ 5, with respect to a T value represented by formula (1) below:

$$T = \{1/(x^2 \cdot R)\} \cdot (\theta/90) \quad \text{...Formula (1)}.$$

2. The micro fluid device according to claim 1, wherein the micro fluid device includes a plurality of the branched portions, a plurality of branched flow paths are connected one by one to the plurality of the branched portions, and

TB-TE $\geq$ 19 is satisfied with respect to each of the branched flow paths.

3. The micro fluid device according to claim 2, further comprising a connection flow path connecting the second expanded flow path portions of the plurality of branched flow paths.

4. The micro fluid device according to any one of claims 1 to 3, further comprising a waste liquid portion connected to the first expanded flow path portion.

5. The micro fluid device according to any one of claims 1 to 4, wherein the branched flow path further comprises a narrowed portion that is connected to an upstream side of the second expanded flow path portion and whose flow path is narrower than the second expanded flow path portion and a remaining portion of the branched flow path.

6. The micro fluid device according to any one of claims 1 to 5, further comprising a liquid sending means on an upstream side of the main flow path.

[FIG. 1.]

1

3

2

4

[FIG. 2.]

11

12

13

12a

15a

15

15b

12b

16a

16

12c

12d

14

17

17a

19

15c

16b

18

16c

17c

17b

[FIG. 3.]

[FIG. 4.]

[FIG. 5]

[FIG. 6]

# INTERNATIONAL SEARCH REPORT

| | International application No. |
|---|---|
| | PCT/JP2018/020171 |

**A. CLASSIFICATION OF SUBJECT MATTER**
Int.Cl. G01N35/08(2006.01)i, B81B1/00(2006.01)i, G01N37/00(2006.01)i

According to International Patent Classification (IPC) or to both national classification and IPC

**B. FIELDS SEARCHED**

Minimum documentation searched (classification system followed by classification symbols)
Int.Cl. G01N35/08, B81B1/00, G01N37/00, B01L3/00

Documentation searched other than minimum documentation to the extent that such documents are included in the fields searched
| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2008-064748 A (SEKISUI CHEMICAL CO., LTD.) 21 March 2008, paragraphs [0024]-[0035], [0052], [0085], fig. 1-5 (Family: none) | 1-6 |
| A | JP 2014-199206 A (SONY CORP.) 23 October 2014, paragraphs [0016]-[0060], [0090]-[0095], fig. 1, 11 & US 2014/0311910 A1, paragraphs [0054]-[0109], [0152]-[0161], fig. 1, 11 & CN 104069903 A | 1-6 |
| A | JP 2005-114430 A (MITSUBISHI CHEMICAL CORP.) 28 April 2005, paragraphs [0032]-[0054], fig. 1-3 (Family: none) | 1-6 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 June 2018 (27.06.2018) | 10 July 2018 (10.07.2018) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
| --- |
| PCT/JP2018/020171 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | WO 2013/045631 A1 (ALBERT-LUDWIGS- UNIVERSITAT FREIBURG) 04 April 2013, entire text, all drawings & DE 102011083920 A1 | 1-6 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002527250 T